(19) Europäisches Patentamt

European Patent Office

Office européen des brevets

(11) EP 1 705 153 A2

(12) **EUROPEAN PATENT APPLICATION**

(43) Date of publication:
27.09.2006 Bulletin 2006/39

(51) Int Cl.:
*B81C 5/00* *(2006.01)*

(21) Application number: 06075586.5

(22) Date of filing: 10.03.2006

(84) Designated Contracting States:
AT BE BG CH CY CZ DE DK EE ES FI FR GB GR HU IE IS IT LI LT LU LV MC NL PL PT RO SE SI SK TR
Designated Extension States:
AL BA HR MK YU

(30) Priority: 23.03.2005 US 88105

(71) Applicant: Delphi Technologies, Inc.
Troy, MI 48007 (US)

(72) Inventor: Jordan, Larry L.
Kokomo, IN 46901 (US)

(74) Representative: Denton, Michael John et al
Delphi European Headquarters,
64 avenue de la Plaine de France,
Paris Nord II,
B.P. 65059, Tremblay en France
95972 Roissy Charles de Gaulle Cedex (FR)

(54) **Bevel dicing semiconductor components**

(57) A semiconductor component is disclosed. The semiconductor component includes a silicon cap (12) that is step-sawn with a dice saw (75) to include at least one horizontal step (HS) and at least one vertical step (VS) for shaping a structure on one or more sides of the silicon cap (12). A semiconductor device (10) is also disclosed. The semiconductor device (10) includes a silicon cap wafer (12a), a bonding media (14), a sensor wafer (16), and a bond pad (20) placed over the sensor wafer (16). The silicon cap wafer (12a) includes the at least one horizontal step (HS) and the at least one vertical step (VS) formed by the dice saw (75) to define a bond pad opening. A method (50) for shaping the semiconductor component with the at least one horizontal step (HS) and the at least one vertical step (VS) is also disclosed.

EP 1 705 153 A2

## Description

FIELD OF THE INVENTION

The invention relates to manufacturing methods of semiconductor devices. More particularly, the invention relates to a methodology for forming bond pad openings in semiconductor devices.

BACKGROUND OF THE INVENTION

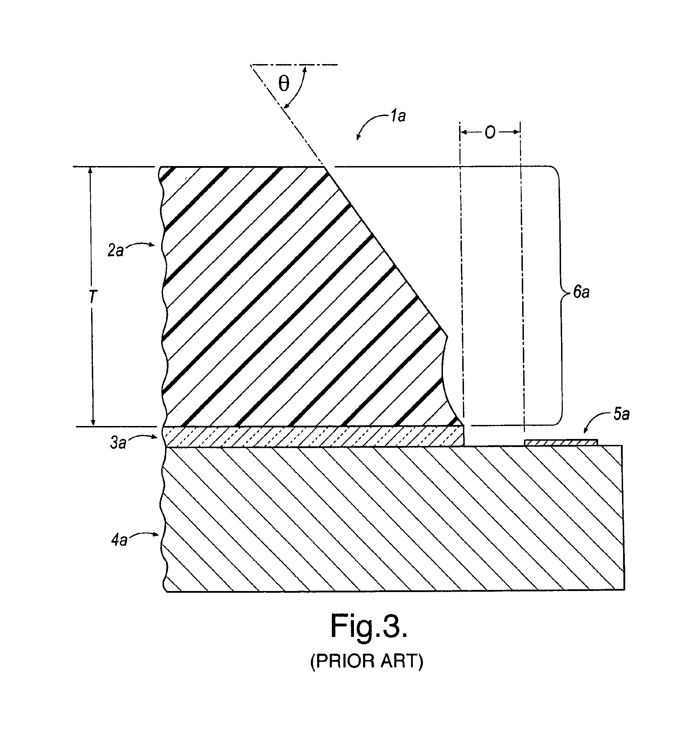

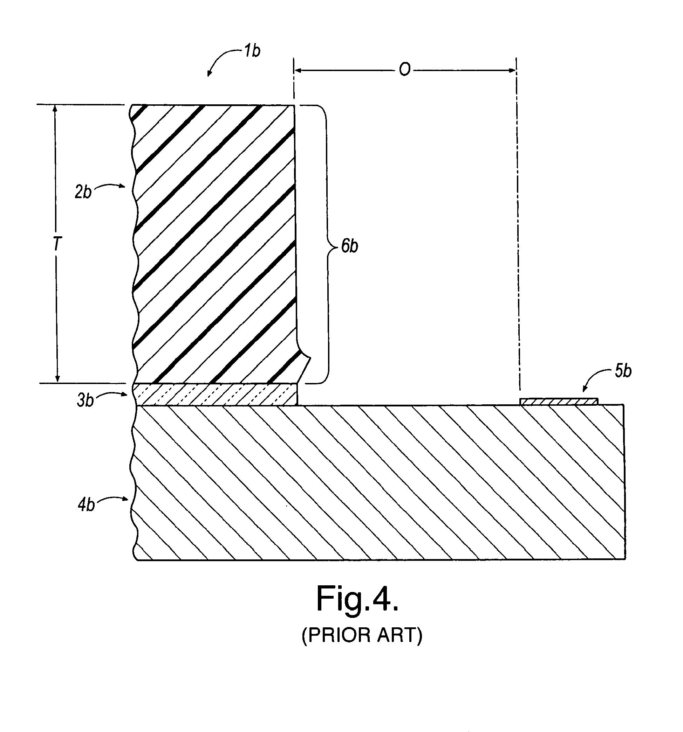

Referring to Figures 3 and 4, conventional semiconductor devices 1a, 1b typically include silicon cap wafer 2a, 2b, a glass frit 3a, 3b, a sensor wafer 4a, 4b, and a bond pad 5a, 5b placed over the sensor wafer 4a, 4b. Bond pad openings are typically formed by etching (Figure 3) or dice sawing (Figure 4) a sidewall 6a, 6b in the silicon cap wafer 2a, 2b. The etched opening results in a bond pad opening with a substantially straight-edge bevelled sidewall 6a, which is usually determined by the silicon crystal orientation, while dice sawing the bond pad opening results in a substantially vertical sidewall 6b.

The substantially straight-edge bevelled sidewall 6a has the advantage of requiring less offset, O, from the bond pads 5a to allow for probing and wire bonding. The etched, substantially straight-edge beveled sidewall 6a includes a relatively large bond pad opening having a clearance angle, $\theta$, approximately equal to 55° while the wire bond tool collets are angled at approximately 70°. Although less offset, O, is required, the etched bond pad opening requires a more costly wafer than sawn bond pad opening wafers. The etched wafers must also be double-side polished with accurately positioned crystal structures. Even further, the etched wafer is also more fragile during the bonding process due to the many holes that are created during the etching operation, requiring a thicker wafer, which is a disadvantage in some chip packages due to limited height in thinner packages. Yet even further, the etched wafer is limited to bond pad openings on non-adjacent sides of the chip, whereas some applications require bond pad openings on all four sides of the chip.

One of the problems associated with dice sawing the bond pad opening is that the substantially vertical sidewall 6b requires that the bond pad offset, O, be longer than the etched, substantially straight-edge beveled sidewall 6a to allow access for probes and wire bond tool bond collets to the bond pad 5b. Depending on thickness, T, of the silicon wafer cap 2b, an additional 5-10 mil setback would be required for the substantially vertical sidewall 6b to accommodate passage of the wire bond tool collet having an approximately 70° bevel in view of the clearance angle, $\theta$, provided by the straight-edge beveled sidewall 6a being approximately equal to 55°. This additional 5-10 mil set back would result in an approximate 5%-10% increase in the size of a 100 mil$^2$ semiconductor device 1b. The percent increase in chip size would be larger for smaller devices or devices with bond pad openings on multiple sides of the chip.

Accordingly, a need therefore exists for a new method for forming bond pad openings in semiconductor devices that allow clearance for tester probes and wire bond tools while maximizing the efficiency in cost and time of forming the bond pad openings.

BRIEF DESCRIPTION OF THE DRAWINGS

The inventor of the present invention has recognized these and other problems associated with forming bond pad openings in semiconductor devices. The present invention will now be described, by way of example, with reference to the accompanying drawings, in which:

Figure 1A is a cross-sectional view of a semiconductor device prior to forming a bond pad opening according to an embodiment;

Figure 1B is a cross-sectional view of the semiconductor device with a formed bond pad opening according to Figure 1A;

Figure 2 is an enlarged cross-sectional view of the semiconductor device of Figure 1A showing a dicing saw forming a bond pad opening sidewall according to an embodiment;

Figure 3 is a cross-sectional view of a conventional semiconductor device including an etched, substantially straight-edge bevelled sidewall; and

Figure 4 is a cross-sectional view of a conventional semiconductor device including a dice sawn, substantially vertical sidewall.

DESCRIPTION OF THE PREFERRED EMBODIMENT

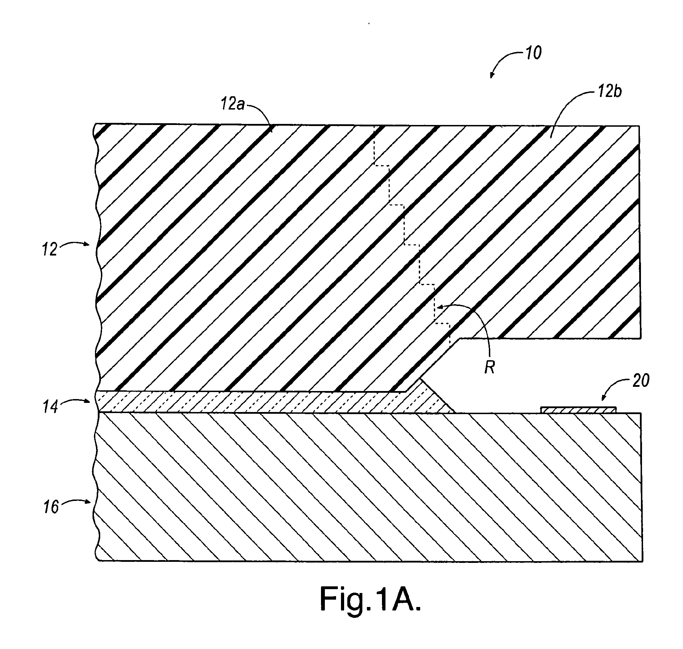

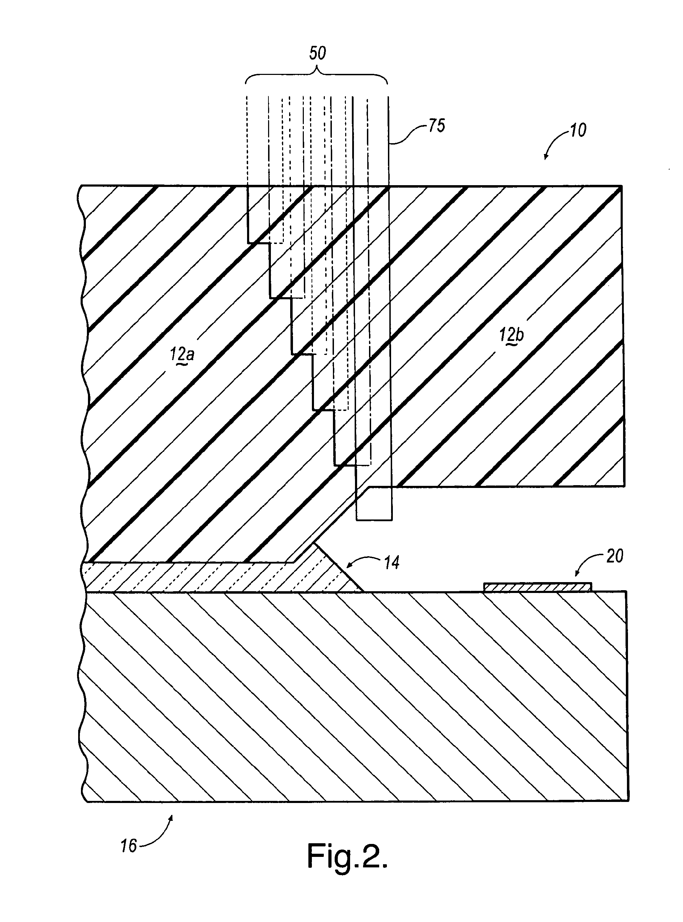

The above-described disadvantages are overcome and a number of advantages are realized by an inventive methodology for forming bond pad openings in semiconductor devices, which is shown generally at 50 in Figure 2. As illustrated in Figure 1A, a pre-worked semiconductor device 10 generally includes a silicon cap 12, a bonding media 14, a sensor wafer 16, and a bond pad 20 placed over the sensor wafer 16. The bond media 14 may be any desirable media, such as, glass frit, solder, or the like, and may be applied using any desirable bonding operation, such as, for example, a direct silicon bonding, a metal annealing process, anodic bonding, or the like. The methodology 50 shown in Figure 2 involves step sawing a silicon cap 12 with a dice saw 75. Referring to Figures 1A and 2, the step-sawing methodology 50 occurs across a release line, R, that defines a silicon cap wafer portion 12a and a released silicon portion 12b.

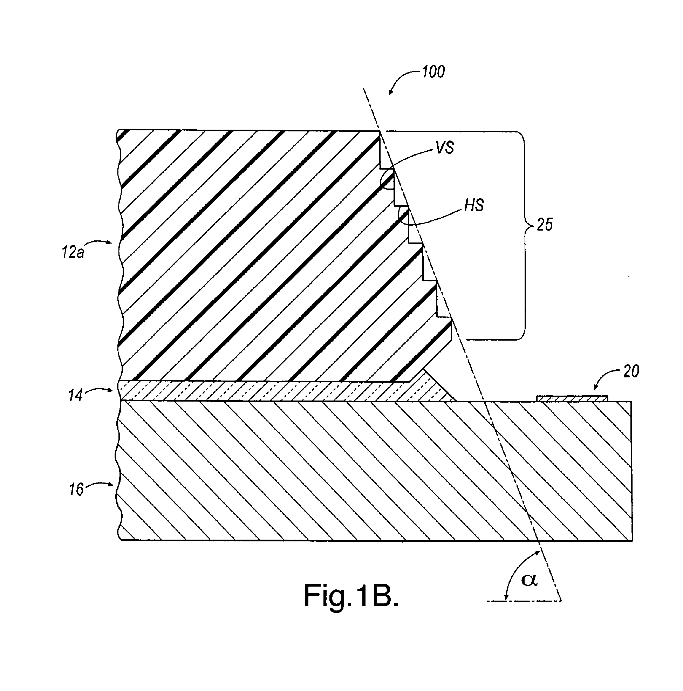

Referring to Figures 1B and 2, the dice saw 75 forms a stepped beveled sidewall 25 defined by a plurality of substantially vertical steps, VS, and substantially horizontal steps, HS. The step-sawing methodology 50 is carried out by successively sawing the silicon cap 12 in a substantially vertical direction, removing the dice saw

75 from the silicon cap 12, horizontally adjusting the position of the dice saw 75, and sawing the silicon cap 12 in the vertical direction at the adjusted horizontal position. According to an embodiment, the length of the horizontal step, HS, may be approximately ½ the width of the dice saw. Upon sawing through the silicon cap 12 along the release line, R, the released silicon portion 12b is discarded and the remaining silicon cap wafer 12a defines the bond pad opening.

The beveled sidewall 25 of the silicon cap wafer 12a defined by the vertical and horizontal steps VS, HS, provides a clearance for the test probe tips and wire bond collets. As illustrated, a clearance angle, α, of the silicon cap wafer 12a is defined in terms of the vertical and horizontal steps VS, HS where

$$\alpha = \tan^{-1}(VS/HS).$$

Accordingly, the clearance angle, α, can be varied to include any desirable clearance by changing the ratio of the vertical and horizontal steps VS, HS. Even further, a "smoothness" gradient of the sidewall 25 may be refined by changing the size and/or number of vertical and horizontal steps VS, HS. As illustrated, the resulting structure is a stepped bevel, which will approximate a substantially straight-edge beveled sidewall 25 in that the vertical and horizontal steps VS, HS are substantially uniform (i.e., each vertical step, VS, and horizontal step, HS, are substantially the same). Conversely, the vertical and horizontal steps VS, HS may be irregularly formed to approximate any desirable sidewall pattern, such as substantially non-uniform, curved sidewall having, for example, a concave shape or a convex shape.

According to the illustrated embodiment, the step-sawing methodology 50 allows for a substantially similar angular clearance, α, for the sidewall 25 as compared to conventional angular clearances, θ, allotted for an etched, substantially straight-edge bevelled sidewall 6a. The efficiency of the step-sawing methodology 50 for forming the bond pad opening coupled with an improved angular clearance, α, allows one skilled in the art to apply a dice sawing technique without incurring the loss in multiple of 5%-10% for a 100 mil semiconductor chip. Another advantage of the step-sawing methodology 50 is that the vertical cutting sequence (i.e. the direction of the vertical steps, VS, during the sawing operation) keeps the tip of the dice saw 75 buried in the silicon cap 12 at a minimal, shallow distance, thus reducing flexing and potential breakage of the dice saw 75. Accordingly, the usable chip area that is saved is an exclusion area required for the test probes and wire bond tools to reach the bond pad 20.

The dice sawing cost attributed to the step-sawing methodology 50 is offset by the fact that since the dice sawing cuts are shallow and the blade tip is constrained by the silicon cap 12, the sawn cuts can be made at very high speeds, thus reducing the dicing time required and thus the cost of the sawn cuts. Even further, the step-sawing methodology 50 allows opening the bond pads on multiple sides of the semiconductor chip 10. Yet even further, the step-sawing methodology 50, provides dice sawing of the semiconductor 10 at the wafer level for double stacked/capped sensor wafers 16, such as, for example, MEMS wafers, which are designed for sawn bond pad openings. Yet even further, another advantage of the step-sawing methodology 50 is that the same blade that dices the bevel is used to separate the chips, which is applicable to a single arbor dicing saw.

Although the illustrated embodiment discusses the use of bond media 14, the step-sawing methodology 50 may be applied to non-bonded wafers. For example, the step-sawing methodology 50 may be used to shape the chip to reduce edge chipping of the silicon cap 12 during removal from dicing tape. In another example, shaped cooling grooves could be formed on the backside of the wafer by using the step-sawing methodology 50. Accordingly, structures may be formed in either side of the wafer prior to a bonding operation. Therefore, after dice sawing the silicon cap 12, the silicon cap wafer portion 12a may be bonded to the sensor wafer 16 with the bond media 14.

While the invention has been specifically described in connection with certain specific embodiments thereof, it is to be understood that this is by way of illustration and not of limitation, and the scope of the appended claims should be construed as broadly as the prior art will permit.

## Claims

1. A semiconductor component comprising:

   a silicon cap (12) having a step shaped surface, wherein said step shaped surface includes at least one horizontal step (HS) and at least one vertical step (VS) for shaping a surface on one or more sides of the silicon cap (12).

2. The semiconductor component according to claim 1, wherein the shaped surface is a beveled sidewall (25) defining a bond pad opening.

3. The semiconductor component according to claim 1, wherein the shaped surface defines a cooling groove formed in the back side of the silicon cap.

4. The semiconductor component according to claim 1, wherein said step shaped surface is formed using a dice saw (75).

5. A semiconductor device (10), comprising:

   a silicon cap wafer (12a), a bonding media (14),

a sensor wafer (16), and a bond pad (20) placed over the sensor wafer (16), wherein the silicon cap wafer (12a) includes at least one horizontal step (HS) and at least one vertical step (VS) formed by a dice saw (75) to define a bond pad opening.

6. The semiconductor device (10) according to claim 5, wherein the bond media (14) is glass frit or solder

7. The semiconductor device (10) according to claim 5, wherein the bond media (14) is applied by a direct silicon bond process, an anodic bond process, or a metal annealing process.

8. The semiconductor device (10) according to claim 5, wherein the at least one horizontal step (HS) is approximately one-half the width of the dice saw (75).

9. The semiconductor device (10) according to claim 5, wherein the at least one horizontal step (HS) and the at least one vertical step (VS) define a beveled sidewall (25) having a clearance angle ($\alpha$) defined in terms of the inverse tangent of a ratio of the at least one vertical step (VS) divided by the at least one horizontal steps (HS).

10. A method (50) for shaping a semiconductor component, comprising the steps of:

   step sawing a silicon cap (12) with a dice saw (75) to form at least one horizontal step (HS) and at least one vertical step (VS) on one or more sides of the silicon cap (12).

11. The method (50) according to claim 10, wherein the step sawing step further comprises the steps of successively sawing the silicon cap (12) in a substantially vertical direction,
removing the dice saw (75) from the silicon cap (12), and horizontally adjusting the position of the position of the dice saw (75) relative the previous sawing of the silicon cap (12) in the substantially vertical direction.

12. The method (50) according to claim 11 further comprising the step of removing a released silicon portion (12b) from the silicon cap (12) once the thickness (T) of the silicon cap (12) has been sawn to form a beveled sidewall (25) defining a bond pad opening for a semiconductor device (10).

13. The method (50) according to claim 12 further comprising the step of bonding the silicon cap wafer portion (12a) to a sensor wafer (16) with the bond media (14).

Fig.1A.

Fig.1B.

Fig.2.

# Fig.3.
## (PRIOR ART)

Fig.4.

(PRIOR ART)